(19) Europäisches Patentamt
European Patent Office
Office européen des brevets

(11) **EP 4 369 599 A1**

(12) **EUROPEAN PATENT APPLICATION**

(43) Date of publication:
**15.05.2024 Bulletin 2024/20**

(21) Application number: **22315266.1**

(22) Date of filing: **09.11.2022**

(51) International Patent Classification (IPC):
**H03F 3/45** (2006.01)

(52) Cooperative Patent Classification (CPC):
**H03F 3/45183; H03F 3/45197; H03F 3/45475;**
H03F 2200/261; H03F 2200/264; H03F 2200/375;
H03F 2203/45512; H03F 2203/45528;
H03F 2203/45546; H03F 2203/45566;
H03F 2203/45594; H03F 2203/45601;
H03F 2203/45632; H03F 2203/45682;
H03F 2203/45701; (Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicants:
• **Commissariat à l'Energie Atomique et aux Energies**
**Alternatives**
**75015 Paris (FR)**
• **Politecnico di Milano**
**20133 Milano (IT)**

(72) Inventors:
• **Langfelder, Giacomo**
**20129 MILANO (IT)**
• **Buffoli, Andrea**
**25069 VILLA CARCINA (BS) (IT)**
• **Gadola, Marco**
**28047 OLEGGIO (IT)**

(74) Representative: **Atout PI Laplace**
**Immeuble Up On**
**25 Boulevard Romain Rolland**
**CS 40072**
**75685 Paris Cedex 14 (FR)**

(54) **MONOLITHICALLY-INTEGRATED CURRENT-FEEDBACK INSTRUMENTATION AMPLIFIER AND SENSING SYSTEM COMPRISING SAID AMPLIFIER**

(57) A monolithically-integrated current-feedback instrumentation amplifier comprising two differential pairs of transistors (M1, M2) and (M3, M4). A drain terminal of transistor (M1) is directly connected to a drain terminal of transistor (M3) and to a differential voltage amplifier (303), and is connected to a ground terminal to a first sink resistor (Rsink). A drain terminal of transistor (M2) is directly connected to a drain terminal of transistor (M4) and to the differential voltage amplifier (303), and is connected to a ground terminal to a second sink resistor (Rsink). An output terminal of the differential voltage amplifier (303) is connected to a resistive voltage divider.

Source terminals of the transistors (M1, M2) are directly connected together and to a first bias current source (301) without a degeneration resistor, and source terminals of the transistors (M3, M4) are directly connected together and to a second bias current source (302) without a degeneration resistor.

The invention also relates to a sensing system comprising a piezoresistive N&MEMS sensor and a monolithically-integrated differential readout circuit comprising said amplifier.

Fig. 3a

(52) Cooperative Patent Classification (CPC): (Cont.)
    H03F 2203/45702; H03F 2203/45728

**Description**

The invention concerns a monolithically-integrated current-feedback instrumentation amplifier and its application as the front-end stage of a sensing system comprising a piezoresistive NEMS (Nano ElectroMechanical System) or MEMS (Micro Electro-Mechanical System) sensor, in particular a Coriolis vibratory gyroscope. It pertains to the. technical fields of microelectronics.

In the market, there is a growing need for MEMS and NEMS-based inertial sensors - accelerators and gyroscopes - with ever-improving performances for applications ranging from "conventional" ones, such as consumer and automotive electronics, to more demanding ones, such as autonomous navigation. A general introduction to MEMS and NEMS-based inertial sensors and their technological evolution is provided in [Langfelder 2021].

Concerning MEMS and NEMS-based gyroscopes, in particular, few architectures have proven capable of achieving the so-called "navigation grade", which requires ultra-low noise (below $0.01°/\sqrt{h}$ ) and longterm stability (below 0.1°/h after up to 1h navigation). In particular, the present inventors and their coworkers have been able to achieve navigation-grade performance using a MEMS Coriolis vibratory gyroscope featuring piezoresistive NEMS gauges, obtained using the so-called M&NEMS technology- see [Dellea 2015] for an exposition of M&NEMS technology and [Gadola 2021] for that of the aforementioned navigation-grade sensing system.

While the sensor used in [Gadola 2021] has an extremely small footprint (1.3 mm$^2$), its operation relies on board-level electronics, which is comparatively large and power-hungry. This defeats the purpose of miniaturizing the sensor, or at the very least it reduces the edge of MEMS and NEMS approach over bulky technologies such as hemispherical resonators or fiber-optic gyroscopes. Thus, there is a need for a navigation grade sensing system combining a miniaturized MEMS/NEMS gyroscope with fully monolithically integrated electronics.

The front-end amplifier is the most demanding stage of the electronics of the sensing system in terms of noise specifications, and thus of current consumption. Otherwise stated, in order to satisfy the stringent noise requirements of navigation grade inertial sensing, the front end amplifier needs to be operated at a sufficiently high current level, which hinders monolithic integration, while holding stable temperatures in the system, due to dissipation. In [Gadola 2021], the front-end amplifier was based on a conventional instrumentation amplifier, with the resistive nano-gauges of the gyroscope included in a Wheatstone bridge, and the achievement of navigation grade noise performances required a current consumption of 10 mA per amplifier, incompatible with monolithic integration while holding a stable system temperature.

An alternative front-end architecture is the so-called pseudodifferential amplifier, which embeds the sensing gauges directly in its first stage, thus avoiding the use of a Wheatstone bridge. Reference [Nikas 2016] discloses a monolithically integrated readout circuit for a M&NEMS gyroscope exploiting this architecture in its front-end amplifiers; however, this circuit does not allow achieving navigation grade noise performances. A detailed noise analysis performed by the inventors shows that such performances would require a current level incompatible with the technology used.

Therefore, there is a need for a new monolithically integrated front-end amplifier with improved noise performances at low current levels, capable of achieving navigation grade noise (and preferably also stability) performances when applied to M&NEMS gyroscope (or, more generally, to a piezoresistive MEMS or NEMS sensor).

According to the invention, these aims are achieved through the use of a modified current-feedback instrumentation amplifier (CFIA). The concept of CFIA has been introduced in 1993 by [Van den Dool 1993], but its noise performances are insufficiently good for the application considered here. The inventors have realized that this is essentially due to the degeneration resistances of its input and feedback transimpedence amplifiers, which act as noise sources. The inventors have further realized that such resistances can be suppressed without significant drawbacks, thus improving the noise performances of the amplifier, making it suitable for the stated aim.

Thus, a first object of the invention is to provide a current-feedback instrumentation amplifier wherein the sources of noise are reduced.

The invention proposes a monolithically-integrated current-feedback instrumentation amplifier comprising:

- a first differential pair of transistors configured for receiving a differential input signal on gate or base terminals of said transistors;
- a second differential pair of transistors configured for receiving a differential feedback signal on gate or base terminals of said transistors;

wherein a drain or collector terminal of a first transistor of the first differential pair is directly connected to a drain or collector terminal of a first transistor of the second differential pair and to a non-inverting, high-impedance input terminal of a differential voltage amplifier, and is connected to a ground terminal to a first sink resistor; and a drain or collector terminal of a second transistor of the first differential pair is directly connected to a drain or collector terminal of a second transistor of the second differential pair and to an inverting, high-impedance input terminal of the differential voltage amplifier, and is connected to a ground terminal to a second sink resistor;
and wherein an output terminal of the differential voltage amplifier, serving as an output terminal of the current-feedback instrumentation amplifier, is connected to a resistive voltage divider providing said differential feedback signal.

According to the invention, source or emitter terminals of the transistors of the first differential pair are directly connected together and to a first bias current source without a degeneration resistor, and source or emitter terminals of the transistors of the second differential pair are directly connected together and to a second bias current source also without a degeneration resistor.

The modified current-feedback instrumentation amplifier of the invention is an optimal solution in terms of power and noise performance.

The noise is very much reduced thanks to the elimination of the degeneration resistor.

This amplifier allows thus reaching navigation-grade performance which requires ultra-low noise.

The present invention also proposes a sensing system comprising a piezoresistive NEMS or MEMS sensor and a monolithically-integrated differential readout circuit. The differential readout circuit comprises, as a front-end amplifier, the current-feedback instrumentation amplifier having any one of the preceding features.

The piezoresistive NEMS or MEMS sensor is preferably a Coriolis vibratory gyroscope.

The amplifier according to the invention has been designed to be used as a front-end amplifier of differential readout circuit of a sensing system comprising a MEMS/NEMS sensor. Because of the achieved results in noise reduction, the amplifier is all the more interesting when used with at the front-end of a Coriolis vibratory gyroscope.

However, the amplifier of the invention could be used for other applications, in particular as a front-end stage of other types of sensing systems, e.g. pressure or stress sensors.

Additional features and advantages of the present invention are described in, and will be apparent from, the description of the presently preferred embodiments which are set out below with reference to the drawings in which:

- Figure 1 represents a model of a single-axis yaw gyroscope;
- Figure 2 is a block diagram of a sensing system according to an embodiment of the invention;
- Figure 3a is a circuit diagram of current feedback instrumentation amplifier according to an embodiment of the invention;
- Figure 3b is a circuit diagram of current feedback instrumentation amplifier of the prior art; and
- Figures 4 and 5 represent results of tests made on the sensing system.

M&NEMS gyroscopes are electromechanical sensors based upon detection of Coriolis accelerations. A mass, or a system of masses, is elastically constrained to a substrate or stator, for instance by suitable springs. The mass is able to translate in a driving direction and a sensing direction that are mutually perpendicular. By a control device, the mass is set in oscillation at a controlled frequency and amplitude in the driving direction.

More specifically, when the gyroscope turns about an axis perpendicular to the driving direction and to the sensing direction at an angular rate, on account of the motion in the driving direction the mass is subject to a Coriolis force and moves in the sensing direction. The displacements of the mass in the sensing direction are determined both by the angular rate and by the velocity in the driving direction and may be converted into electrical signals.

In the present invention, the displacements are sensed thanks to piezoresitve gauges as explained further, in contrast with the conventional used capacitive sensing systems.

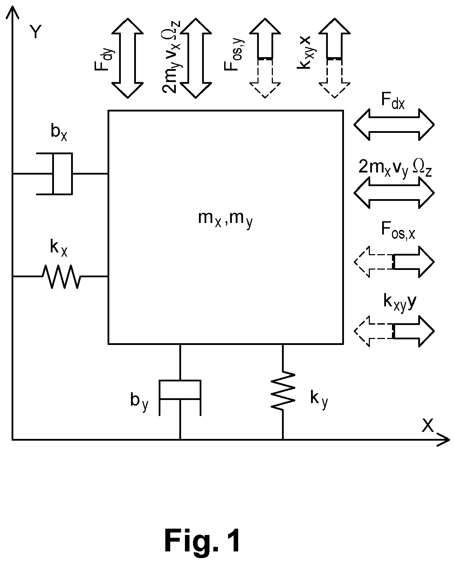

Figure 1 represents a model of a single-axis yaw gyroscope. The gyroscope is modeled by a system of coupled equations describing the two lumped spring-mass damper systems :

$$m_x\ddot{x} + b_x\dot{x} + k_x x = F_x = F_{dx} + 2\alpha m_x v_y \Omega_z + F_{osx} + k_{xy}y$$

$$m_y\ddot{y} + b_y\dot{y} + k_y y = F_y = F_{dy} - 2\alpha m_y v_x \Omega_z + F_{osy} + k_{xy}x$$

with m being the effective mass, k the effective stiffness of the suspending springs, b the effective damping coefficient. F includes the apparent forces acting on the mass, namely the electrostatic driving force for the $i^{th}$ oscillating axis $F_{di}$ and offset forces $F_{os}$. Subscripts $x$ and $y$ refer to the corresponding motion axis and $\alpha$ being the angular gain of the structure, a modal-mass-related coefficient that quantifies the Coriolis-induced coupling between two modes, drive mode and sense mode. The term $k_{xy}$ represents an imperfect decoupling between the two axes, otherwise coupled only by the Coriolis force $F_{Cor}$.

The gyroscope in the present invention relies on AM (amplitude modulated) working principles, wherein only one axis is kept in oscillation through electrostatic forces. The drive-mode is continuously excited at resonance, and the sense-mode is used for rate detection.

In the above-system of equations, when the drive axis is the x-axis, $F_{dy}$ is equal to zero. The displacement y is proportional to the vibratory angular rate $\Omega z$. The angular rate $\Omega z$ is thus determined from the measurement of the displacement y.

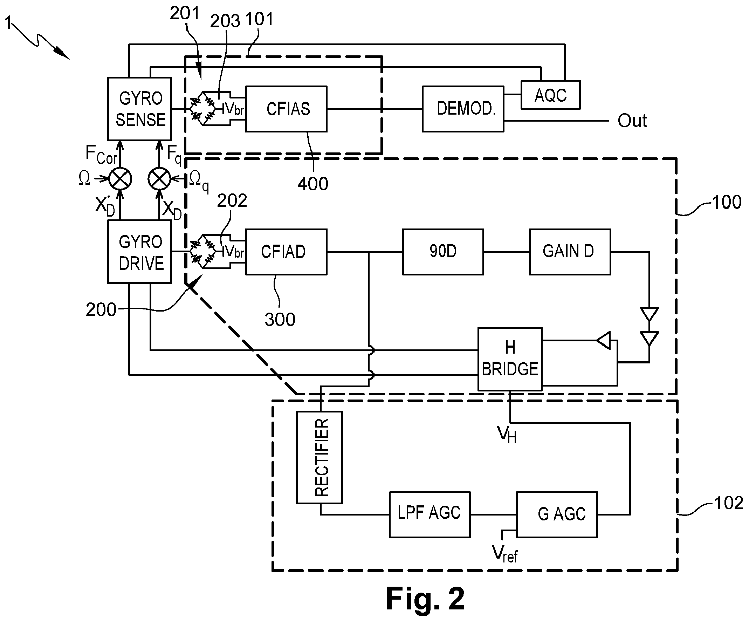

Figure 2 represents a block scheme of a sensing system 1 according to an embodiment of the invention.

The sensing system comprises a piezoresistive NEMS or MEMS sensor and an integrated differential readout circuit.

The piezoresistive NEMS/MEMS sensor is here a Coriolis. vibratory gyroscope.

The differential readout circuit embeds blocks of the gyroscope, in particular a drive loop 100, a sense chain 101, an automatic gain control loop 102 and a bandgap generator (not shown in the figures).

The Coriolis vibratory gyroscope comprises a first pair of piezoresistive gauges 200 and a second pair of piezoresistive gauges 201.

The first pair of the piezoresistive gauges 200 is part of the drive loop. The first pair of piezoresistive gauges 200 senses a driven oscillation of a test mass along a first direction or driving direction, for instance the x direction in figure 1.

The second pair of piezoresistive gauges 201 is part of the sense chain. The second pair of piezoresistive gauges 201 senses a displacement of the test mass along a second direction or sensing direction, perpendicular to the first direction, induced by Coriolis force $F_{Cor}$, for instance the y direction in figure 1 .

The piezoresistive gauges of each pair 200, 201 are electrically connected to each other. The first pair of piezoresistive gauges 200 are connected to a reference voltage terminal 202. The second pair of piezoresistive gauges 201 are connected to a reference voltage terminal 203. Each of the reference voltage terminals 202, 203 imposes a voltage Vbr. .

The piezoresistive gauges 200, 201 are biased by voltage Vbr in a Wheatstone bridge configuration. The piezoresistive gauges of each pair belong to different legs of the respective Wheatstone bridge.

Upon application of a same displacement of the test mass, the resistance values of the piezoresistive gauges of each pair 200, 201 change by opposite amounts.

The differential readout circuit further comprises two current-feedback instrumentation amplifiers (also referred to here as CFIA), as front-end amplifiers. The first CFIA 300 is part of the drive loop 100. The second CFIA 400 is part of the sense chain 101. Both the first CFIA 300 and the second CFIA 400 are monolithically co-integrated.

The differential output of each of the Wheatstone bridges is connected to the input of the respective CFIA 300, 400 as detailed further.

The system further comprises a digital demodulator and a quadrature compensation loop, connected to the sense chain 101, both not detailed herein.

The drive loop 100 further comprises a 90° phase shifting block 90D, connected to the CFIA 300, followed by a gain stage GAIN D, and a H-bridge.

The 90D-stage introduces a 90° shift to the signal coming from the CFIA 300.

The 90D stage output signal is high-pass-filtered to remove any residual offset and then amplified to saturation by the gain stage. The gain stage saturates the signal. The saturated signal passes through two inverters for edge restoring, and is used, together with a further inversion, as the input signal for the H-bridge.

The H-bridge is used as the actuation stage to bias drive comb-fingers. The H-bridge is configured to generate a differential squarewave driving signal, between 0 V and $V_H$ for the proper bias of the actuation comb-fingers. The driving force amplitude, and thus the drive motion amplitude, are set by the value of $V_H$, which comes from the amplitude-gain control stage.

The automatic gain control loop (AGC) is a negative loop that extracts the mean value of the CFIA 300, exploiting a rectifier followed by a lowpass- filter LPF, compares it with a reference voltage $V_{ref}$ and amplifies it to generate the upper voltage level $V_H$ for the push-pull actuation signal.

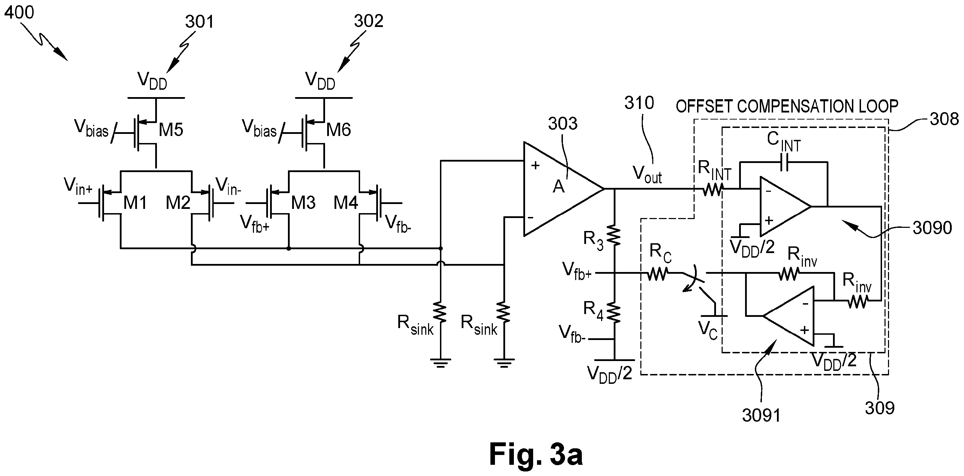

Figure 3a is a circuit diagram of current feedback instrumentation amplifier 400 according to an embodiment of the invention. Preferably, the CFIA 300 of the drive loop 100 and the corresponding offset-nulling circuit are implemented in the same way.

The CFIA 400 comprises a first bias current source 301 and a second bias current source 302. Each of the first bias current source 301 and the second bias current source 302 has a supply voltage $V_{DD}$.

The CFIA comprises two differential pairs of transistors, namely a first differential pair of transistors M1 and M2, and a second differential pair of transistors M3 and M4.

In the present embodiment, the input transistors M1, M2 are pMOS transistors which are preferred due to their low 1/f noise. It will be understood, however, that nMOS transistors, or even transistors of different technologies such as JFET or bipolar transistor can be used. Adapting the circuit topology to these different types of transistors is trivial.

The first differential pair of transistors M1, M2, also called input pair of transistors, comprises a first transistor M1 and a second transistor M2. The input pair of transistors M1, M2 is configured for receiving a differential input signal voltage $V_{in+}$, $V_{in-}$ on gate terminals of the transistors M1, M2.

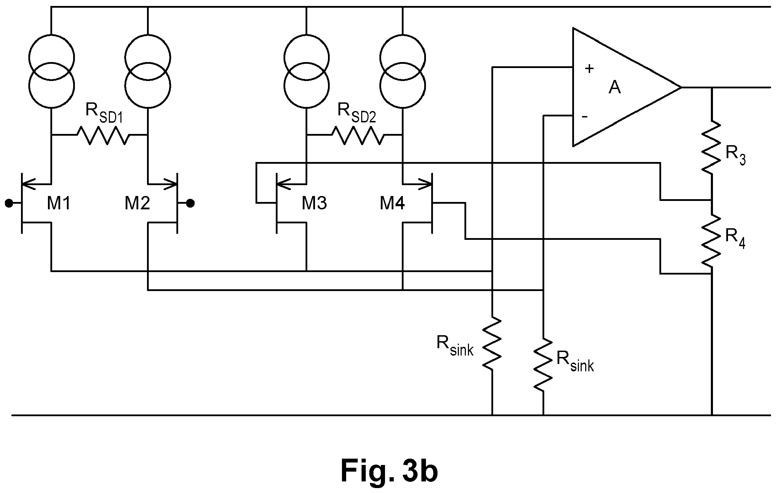

Source terminals of the transistors of the first differential pair of transistors M1, M2 are directly connected together and to the first bias current source 301 without a degeneration .resistor. By way of comparison, figure 3b shows a circuit diagram of a CFIA according to the prior art (cf. [Van den Dool 1993]), wherein the sources of the transistors of each differential pair are interconnected through a source degeneration resistor $R_{SD1}$, $R_{SD2}$.

The input transistors M1, M2, are preferably pMOS transistors. pMOS transistors present the advantage of having a low noise (1/f).

The second differential pair of transistors M3, M4, also called feedback pair of transistors, comprises a first transistor M3 and a second transistor M4. The feedback pair of transistors M3, M4 is configured for receiving a differential feedback signal voltage $V_{fb+}$, $V_{fb-}$ on gate terminals of the transistors M3, M4.

Like in the case of the first pair of transistors, source terminals of the transistors of the second differential pair of transistors M3, M4 are connected together and to the second bias current source 302. The second differential pair of transistors M3, M4 are directly connected together. In particular, the second differential pair of transistors M3, M4 are connected without a degeneration resistor.

The CFIA also comprises a non-inverting differential voltage amplifier 303, such as an operational amplifier. The differential voltage amplifier 303 presents a high input impedance.

The CFIA also comprises two identical sink resistors $R_{sink}$.

The differential voltage amplifier 303 has preferably an input impedance at least ten times larger and preferably at least one hundred time larger than the sink resistors $R_{sink}$.

A drain terminal of the first transistor M1 of the input pair of transistors is connected to the non-inverting input terminal of the differential voltage amplifier 303 and to a ground terminal to a first of the sink resistors $R_{sink}$.

A drain terminal of the second transistor M2 of the input pair of transistors is connected to the inverting input terminal differential voltage amplifier 303 and to a ground terminal to a second of the sink resistors $R_{sink}$.

The CFIA further comprises a voltage divider connected to an output terminal of the differential voltage amplifier 303. The voltage divider provides the differential feedback signal driving the feedback pair of transistors M3, M4.

The voltage divider is here formed by two resistors R3, R4 connected in series. The feedback signal is acquired across gain resistor R4 of the voltage divider, i.e. across the resistor connected between the mid-point of the voltage divider and the ground.

A drain terminal of the first transistor M3 of the feedback pair of transistors is directly connected to a drain terminal of the first transistor M1 of the input pair of transistors, and a drain terminal of the second transistor M4 of the feedback pair of transistors is directly connected to a drain terminal of the second transistor M2 of the input pair of transistors. These connections implement a negative current feedback.

It will be understood that, if the CFIA is based on bipolar technology, the terms "gate", "source" and "drain" shall be replaced by "base", "emitter" and "collector" respectively.

The CFIA 400 further comprises an offset-nulling circuit 308. The offset nulling circuit comprises an inverting voltage integrator 309 formed by an operational-amplifier-based integrator 3090 and an operational-amplifier-based inverting circuit 3091.

The voltage integrator 309 is connected to the output terminal of the differential voltage amplifier 303.

An output. terminal of the inverting voltage integrator 309 is connected to a mid-point of the voltage divider through a compensation resistor Rc. The voltage divider is connected between the output terminal of the differential voltage amplifier 303 and a reference voltage terminal 310 of the offset-nulling circuit 308.

It is worth noting that the offset nulling circuit, by itself,. is known from e.g. [Gadola 2021], but only applied to an instrumentation amplifier. Its application to a CFIA, through the compensation resistor connected to the mid-point of the feedback voltage divider, is not trivial.

Alternatively, "static" offset nulling can be obtained by connecting the compensation resistor Rc to a predetermined compensation voltage $V_c$.

The CFIA functions as follows.

The input pair of transistors M1, M2, forming a first transimpedance amplifier, is unbalanced by the input voltage signal $V_{in}$ coming from the respective Wheatstone bridge. This generates a current $i_{in}$ that flows into the two sink resistors $R_{sink}$.

A signal is thus created at the input of the differential voltage amplifier 303 that creates a voltage difference across the gain resistor R4. This signal is then read by the feedback pair of transistors M3, M4 forming a second transimpedance amplifier, which in turn generates a current $i_{fb} = -i_{in}$. All the current of the input pair of transistors M1, M2 is thus forced to recirculate into the feedback transistors M3, M4.

Considering the input and feedback transimpedance amplifiers to be identical, the negative feedback equals the current in the two differential pairs. The input voltage is thus « copied » across the resistance R4. The ideal gain of the stage is then:

$$G_{CFIA} = \frac{G_{m,in}}{G_{m,fb}} \cdot \left(1 + \frac{R_3}{R_4}\right) = \left(1 + \frac{R_3}{R_4}\right)$$

with $G_{m,in}$ and $G_{m,fb}$ being the respective gains of the input and feedback amplifiers.

In the present implementation, there are no source degeneration resistors between the sources of the input transistors and the current source. For low-noise applications, this avoids that the high current needed for the input and feedback transistors creates a voltage drop across the degeneration resistors, limiting the input common mode. Additionally, this solution avoids introducing additional resistive noise.

The rationale for introducing source degeneration resistors is to improve part-to-part repeatability. However, as the gain of the CFIA depends on the ratio of the transconductances of two monolithically co-integrated transistors very close to each other, the reduction in part-to-part repeatability resulting from the suppression of source degeneration resistors is negligible.

The input-referred noise analysis of the CFIA of figure 3a is now presented.

The noise from transistors $M1$, $M2$, $M3$, $M4$ contribute directly to the input referred noise, as well as the one from the gain resistor R4 . The other contributions can be calculated by considering the open-loop transfer function from input to output. Thus, the input referred noise power spectral density $S_{v,\,in}$ results:

$$\begin{aligned}
S_{v,in} &= 4S_{M1} + S_{R4} + S_{R3} + S_{R_{sink}} + S_{OTA} \\
&= 4\left(\frac{4k_BT\gamma}{g_{m1}} + S_{1/f}\right) + 4k_BTR_4 + \frac{4k_BTR_3}{G_{CFIA}^2} + \\
&+ \frac{4k_BT}{R_{sink}}\left(\frac{1}{g_{m1}}\right)^2 + S_{v,in,OTA}\left(\frac{1}{g_{m1}R_{sink}}\right)^2 \\
&\approx 4\left(\frac{4k_BT\gamma}{g_{m1}} + S_{1/f}\right) + 4k_BTR_4
\end{aligned}$$

In the equation above:

- $S_x$ (with x = M1, R4, R3, $R_{sink}$, OTA) is the noise contribution of each component (OTA representing the operational transconductance amplifier 303);
- $k_B$ is the Boltzmann constant;
- T is the absolute temperature;
- y is a multiplicative coefficient for MOSFET thermal noise;
- $g_{m1}$ is the transconductance of M1;
- $S_{1/f}$ is the power spectral density of the 1/f of M1;
- $S_{v,in,OTA}$ is the input referred noise power spectral density of the operational transconductance amplifier 303.

The contribution $S_{v,in,OTA}$ of the differential voltage amplifier 303 is made negligible through a proper sizing, and the contributions from the resistors R3 and Rsink can be neglected.

Each term of the preceding equation can be lowered by increasing the current in the input and feedback pairs, except for R3 and R4.

It is noticeable that in the conventional instrumentation amplifiers of prior art, the noise is also determined by four transistors used as active loads in the first stage, while in the CFIA of the present invention, they are replaced by the two sink resistors *Rsink,* thus lowering the noise sources. Also, the 1/*f* noise of the differential pairs is lowered by a proper sizing and made a factor 4 lower than their white noise.

The following table shows a proposed sizing of the CFIA.

| | $W[\mu m]$ | $L[\mu m]$ | $I[\mu A]$ | $V_{ov}[V]$ |
|---|---|---|---|---|
| $M_{1,2,3,4}$ | 800 | 1 | 325 | 0.18 |

(continued)

|  | $W[\mu m]$ | $L[\mu m]$ | $I[\mu A]$ | $V_{ov}[V]$ |
|---|---|---|---|---|
| $M_{5,6}$ | 385 | 2 | 650 | 0.4 |
| Passive components value | | | | |

| $R_{sink}$ | 2 kΩ | $R_C$ | 14 kΩ |
|---|---|---|---|
| $R3$ | 7 kΩ | $R_{inv}$ | 100 kΩ |
| $R_4$ | 342 Ω | $C_{int}$ | 70 pF |
| $R_3$ | 7 kΩ | $R_{int}$ | 7.5 MΩ |

With this proposed sizing, a noise level of $5.2 \ nV \ / \ \sqrt{Hz}$ is reached, with a total current consumption of 1.65 mA and a nominal gain of 21.

The designed CFIA features a selectable gain and offset compensation, implemented both in an open-loop and a closed-loop solution. The CFIA selectable gain is a useful degree of freedom to test devices of the same family, but with different electromechanical gain. The selectable gain is implemented by connecting in parallel a multiplicity of identical resistors for the gain resistance $R4$, in particular the gain values were chosen to be equal to 12.67, 21.42, 36 and 44.75. The higher the device sensitivity, the lower the gain needed, so to avoid saturation of the front-end.

The automatic offset compensation loop consists in connecting the compensation resistor Rc at the node between resistors R3, R4 and to properly bias it with a voltage $V_C$ to create an output voltage contribution that counteract to the one given by the gauge offset, which is measured by averaging the output through an integrator.

Said otherwise, the output signal of the amplifier 303 is filtered by an integrating stage and then inverted and compared to $V_{DD}/2$ by a unitary gain stage, which automatically generates the proper $V_C$ voltage to be applied to the compensation resistance Rc. The reference voltage terminal is thus kept at a potential substantially equal to half the supply voltage $V_{DD}$ of the first and second current sources 301, 302 and of the differential voltage amplifier.

$$V_{out} = \frac{V_{DD}}{2} + (V_{in} + V_{os})\left(1 + \frac{R_3}{R_4 \parallel R_C}\right) + \\ + \left(\frac{V_{DD}}{2} - V_C\right)\frac{R_3}{R_C}$$

with $V_{os}$ being the offset contribution to the output voltage $V_{out}$ of the voltage amplifier 303.

The value of the compensation resistor Rc is chosen to be much higher than that of the gain resistor R4, e.g. by a factor of ten. This avoids changes in the stage gain, so the added noise is negligible. For instance, the compensation resistor Rc has a resistance at least ten times greater than that of the gain resistor R4.

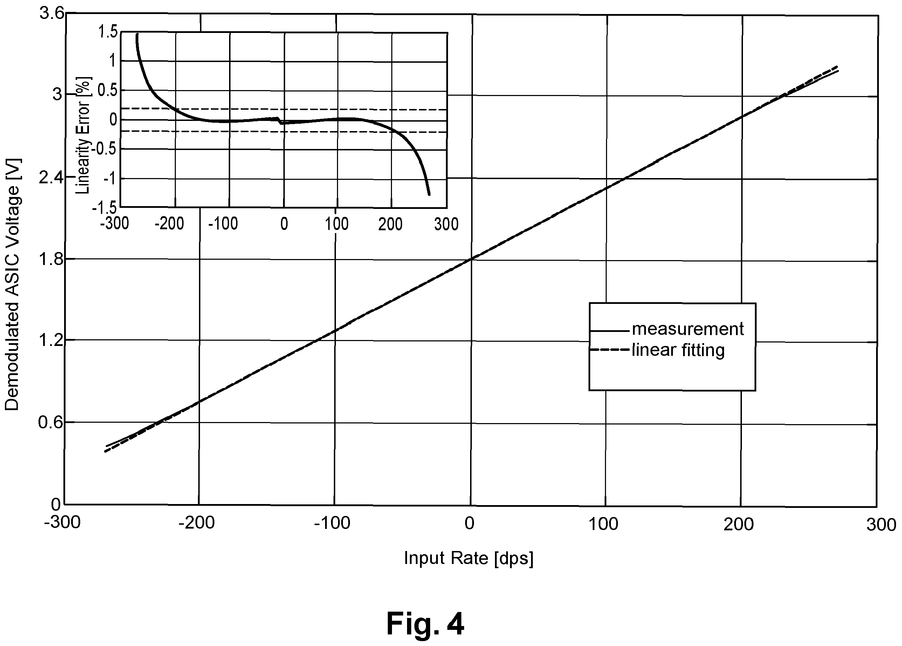

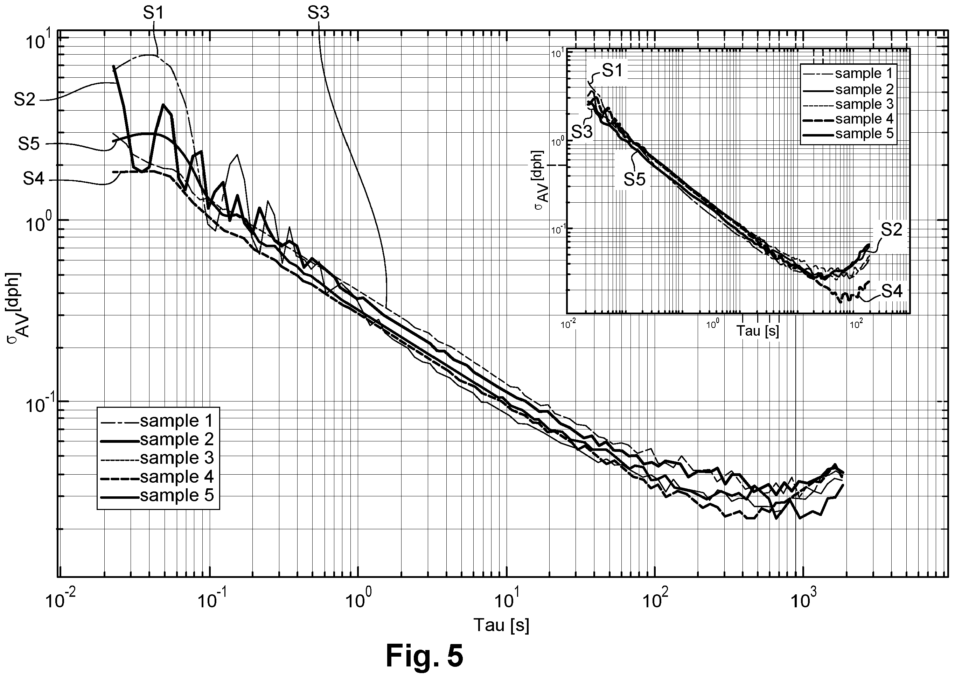

Figures 4 and 5 show results of experimental measurements made on the sensing system of the invention. The system is tested on a testing machine, namely a rate table, for linearity measurements.

A quasi stationary rate ramp from -270 *dps* to 270 *dps* (dps: degree per second) is applied and the integrated circuit is captured 10 times and averaged. The linearity error is reported on figure 4, without any correcting procedure, and normalized to the 200 dps full-scale. The linearity error is lower than 0.2 % up to 200 dps (visible on the inset). Saturation of the integrated circuit begins to be visible at the trace edges.

Figure 5 shows Allan variance for five tested samples (referenced S1 to S5 on the figure) in order to characterize noise and stability. Allan variance curves are captured under uncontrolled laboratory environment (maximum temperature variations during measurements of ±4°C) for a duration of more than 5 hours. After applying the Allan variance formula with a minimum of 10 averages, the results are represented in figure 5 for an observation interval that consequently spans 1865 s. The results obtained with the integrated circuit are well comparable to those obtained with board-level electronics (shown in the inset of figure 5).

This confirms the low noise introduced by the CFIA front-end and the dominant thermo-mechanical source, giving an angle random walk in the range of $0.004°/\sqrt{h}$) to $0.006°/\sqrt{h}$).

At the same time, the stability lies in a range between 0.02 °/h and 0.03°/h, for observation intervals slightly longer than for board-level electronics. No device rises above 0.04◦/h after 1000 s of observation. Combined with noise results, this yields navigation grade performance within less than 10 mA of overall consumption.

The invention provides with a MEMS process featuring piezoresistive NEMS gauges and, as a front-end amplifier, a modified CFIA that minimizes noise, with a dedicated offset compensation circuit to enhance stability and preserve the full-scale. The optimization of the front-end CFIA is even more interesting in the case of Coriolis vibratory gyroscope MEMS characterized by a significant offset, usually larger than other MEMS.

The modified CFIA of the invention is an optimal choice in terms of noise and current consumptions, and allows reaching navigation-grade performance with an overall consumption well below 10 mA.

**Bibliography**

[Langfelder 2021] : G. Langfelder, M. Bestetti, and M. Gadola, "Silicon mems inertial sensors evolution over a quarter century," Journal of Micromechanics and Microengineering, vol. 31, no. 8, p. 084002, 2021.

[Dellea 2015] : S. Dellea, F. Giacci, A. F. Longoni, and G. Langfelder, "In-plane and out-of-plane mems gyroscopes based on piezoresistive nems detection," Journal of Microelectromechanical Systems, vol. 24, no. 6, pp. 1817-1826, 2015.

[Gadola 2021] : M. Gadola et al., "1.3 mm2 nav-grade nems-based gyroscope," Journal of Microelectromechanical Systems, vol. 30, no. 4, pp. 513-520, 2021.

[Nikas 2016] : A. Nikas et al., "A 83db sndr low power readout asic for piezoresistive nanogauge based gyroscopes," in IEEE International Symposium on Circuits and Systems, pp. 2238-2241, 2016.

[Van den·Dool 1993] B. van den Dool and J. Huijsing, "Indirect current feedback instrumentation amplifier with a common-mode input range that includes the negative roll," IEEE Journal of Solid-State Circuits, vol. 28, no. 7, pp. 743-749, 1993.

**Claims**

1. A monolithically-integrated current-feedback .instrumentation amplifier comprising:

   - a first differential pair of transistors (M1, M2) configured for receiving a differential input signal ($V_{in+}$, $V_{in-}$) on gate or base terminals of said transistors (M1, M2);
   - a second differential pair of transistors (M3, M4) configured for receiving a differential feedback signal ($V_{fb+}$, $V_{fb-}$) on gate or base terminals of said transistors (M3, M4);
   wherein a drain or collector terminal of a first transistor (M1) of the first differential pair (M1, M2) is directly connected to a drain or collector terminal of a first transistor (M3) of the second differential pair (M3, M4) and to a non-inverting, high-impedance input terminal of a differential voltage amplifier (303), and is connected to a ground terminal to a first sink resistor (Rsink); and a drain or collector terminal of a second transistor (M2) of the first differential pair (M1, M2) is directly connected to a drain or collector terminal of a second transistor (M4) of the second differential pair (M3, M4) and to an inverting, high-impedance input terminal of the differential voltage amplifier (303), and is connected to a ground terminal to a second sink resistor ($R_{sink}$); and wherein an output terminal of the differential voltage amplifier (303), serving as an output terminal of the current-feedback instrumentation amplifier, is connected to a resistive voltage divider providing said differential feedback signal ($V_{fb+}$, $V_{fb-}$);
   **characterized in that** source or emitter terminals of the transistors of the first differential pair (M1, M2) are directly connected together and to a first bias current source (301) without a degeneration resistor, and source or emitter terminals of the transistors of the second differential pair (M3, M4) are directly connected together and to a second bias current source (302) also without a degeneration resistor.

2. The current-feedback instrumentation amplifier of claim 1 wherein the resistive voltage divider is connected between said output terminal of the differential voltage amplifier (303) and a reference voltage terminal (310).

3. The current-feedback instrumentation amplifier of claim 2 wherein said reference voltage terminal (310) is kept at a potential substantially equal to half a supply voltage ($V_{DD}$) of the first and second current sources (301, 302) and of the differential voltage amplifier (303).

4. The current-feedback instrumentation amplifier of any one of claims 2 or 3, wherein the feedback signal is acquired across a gain resistor (R4) of the resistive voltage divider.

5. The current-feedback instrumentation amplifier of any one of the preceding claims, further comprising an offset-nulling circuit (308) comprising an inverting voltage integrator (309) connected to the output terminal of the differential voltage amplifier (303), an output terminal of said inverting voltage integrator (309) being connected to a mid-point of said resistive voltage divider through a compensation resistor (Rc).

6. The current-feedback instrumentation amplifier of claim 5, wherein the resistive voltage divider is connected between said output terminal of the differential voltage amplifier (303) and a reference voltage terminal (310), wherein the feedback signal is acquired across a gain resistor (R4) of the resistive voltage divider and wherein the compensation resistor (Rc) has a resistance at least ten times greater than the gain resistor (R4).

7. The current-feedback instrumentation amplifier of any one of claims 5 and 6, wherein the compensation resistor (Rc) has a programmable resistance.

8. A sensing system comprising a piezoresistive NEMS or MEMS sensor and a monolithically-integrated differential readout circuit, **characterized in that** the differential readout circuit comprises, as a front-end amplifier, the current-feedback instrumentation amplifier (300, 400) of any one of the preceding claims.

9. The sensing system of claim 8, wherein the piezoresistive NEMS or MEMS sensor comprises a pair of piezoresistive gauges (200, 201) whose resistance value changes by opposite amounts upon application of a stimulus to the sensor, said piezoresistive gauges (200, 201) being electrically connected to each other and to a reference voltage terminal and belonging to different legs of a Wheatstone bridge, the gate or base terminals of the first differential pair of transistors (M1, M2) of the current-feedback instrumentation amplifier being connected to respective midpoints of said legs.

10. The sensing system of any one of claims 8 or 9 wherein the piezoresistive NEMS or MEMS sensor is a Coriolis vibratory gyroscope.

11. The sensing system of claim 10 wherein the Coriolis vibratory gyroscope comprises a first pair of .piezoresistive gauges (200) for sensing a driven oscillation of a test mass along a first direction and a second pair of piezoresistive gauges (201) for sensing a displacement of the test mass along a second direction, perpendicular to the first direction, induced by Coriolis force, the resistance values of the piezoresistive gauges of each pair (200, 201) changing by opposite amounts upon application of a same displacement of the test mass, the piezoresistive gauges of each pair (200, 201) being electrically connected to each other and to a reference voltage terminal and belonging to different legs of a respective Wheatstone bridge, the gate or base terminals of the first differential pair of transistors (M1, M2) of a respective current-feedback instrumentation amplifier (300, 400) according to any one of claims 1 to 7 being connected to respective midpoints of said legs of each Wheatstone bridge, both current-feedback instrumentation amplifiers (300, 400) being monolithically co-integrated.

**Fig. 1**

**Fig. 2**

EP 4 369 599 A1

Fig. 3a

Fig. 3b

Fig. 4

Input Rate [dps]

Demodulated ASIC Voltage [V]

Linearity Error [%]

measurement
linear fitting

Fig. 5

Europäisches
Patentamt

European
Patent Office

Office européen
des brevets

**EUROPEAN SEARCH REPORT**

Application Number

EP 22 31 5266

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 202 738 B1 (HUIJSING JOHAN HENDRIK [NL] ET AL) 10 April 2007 (2007-04-10) | 1-4,8-11 | INV. H03F3/45 |
| A | * column 1, line 13 - column 2, line 3; figures 1, 3 * | 5-7 | |
| X,D | VAN DEN DOOL B J ET AL: "INDIRECT CURRENT FEEDBACK INSTRUMENTATION AMPLIFIER WITH A COMMON-MODE INPUT RANGE THAT INCLUDES THE NEGATIVE RAIL", IEEE JOURNAL OF SOLID-STATE CIRCUITS, IEEE, USA, vol. 28, no. 7, 1 July 1993 (1993-07-01), pages 743-749, XP000322303, ISSN: 0018-9200, DOI: 10.1109/4.222171 | 1-4,8-11 | |
| A | * section III. entitled "Circuit Description"; page 744 - page 747; figure 5 * | 5-7 | |
| A | Razavi Behzad: "Design of Analog CMOS Integrated Circuits: 3.3.6 CS Stage with Source Degeneration" In: "Design of Analog CMOS Integrated Circuits: 3.3.6 CS Stage with Source Degeneration", 1 January 2017 (2017-01-01), XP093041785, pages 1-8, * page 61 - page 62 * | 1-11 | |
| A | Anonymous: "advantage of source degeneration? ¦ Forum for Electronics", , 17 December 2007 (2007-12-17), pages 1-7, XP093041783, Retrieved from the Internet: URL:https://www.edaboard.com/threads/advantage-of-source-degeneration.113207/ [retrieved on 2023-04-24] * page 1 - page 5 * | 1-11 | |

TECHNICAL FIELDS SEARCHED (IPC)

H03F

-/--

The present search report has been drawn up for all claims

| Place of search | Date of completion of the search | Examiner |
|---|---|---|
| The Hague | 25 April 2023 | Wienema, David |

EPO FORM 1503 03.82 (P04C01)

Europäisches
Patentamt

European
Patent Office

Office européen
des brevets

# EUROPEAN SEARCH REPORT

Application Number

EP 22 31 5266

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | QINWEN FAN ET AL: "A 21 nV/ $\surd$ Hz Chopper-Stabilized Multi-Path Current-Feedback Instrumentation Amplifier With 2 $\mu$ V Offset", IEEE JOURNAL OF SOLID-STATE CIRCUITS, IEEE, USA, vol. 47, no. 2, 1 February 2012 (2012-02-01), pages 464-475, XP011453548, ISSN: 0018-9200, DOI: 10.1109/JSSC.2011.2175269 * paragraph [00II] – paragraph [00IV]; figures 5, 12 * | 1-11 | |
| A | AHMED MOAAZ ET AL: "Fully Integrated Bidirectional CMOS-MEMS Flow Sensor With Low Power Pulse Operation", IEEE SENSORS JOURNAL, IEEE, USA, vol. 19, no. 9, 1 May 2019 (2019-05-01), pages 3415-3424, XP011718032, ISSN: 1530-437X, DOI: 10.1109/JSEN.2019.2891784 [retrieved on 2019-04-03] * section III entitled "Design considerations for CMOS readout circuit".; figures 6, 7 * | 1-11 | TECHNICAL FIELDS SEARCHED (IPC) |

The present search report has been drawn up for all claims

| Place of search | Date of completion of the search | Examiner |
|---|---|---|
| The Hague | 25 April 2023 | Wienema, David |

EPO FORM 1503 03.82 (P04C01)

## ANNEX TO THE EUROPEAN SEARCH REPORT
## ON EUROPEAN PATENT APPLICATION NO.

**EP 22 31 5266**

This annex lists the patent family members relating to the patent documents cited in the above-mentioned European search report.
The members are as contained in the European Patent Office EDP file on
The European Patent Office is in no way liable for these particulars which are merely given for the purpose of information.

**25-04-2023**

| Patent document cited in search report | Publication date | Patent family member(s) | Publication date |
|---|---|---|---|
| US 7202738 B1 | 10-04-2007 | NONE | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. LANGFELDER ; M. BESTETTI ; M. GADOLA.** Silicon mems inertial sensors evolution over a quarter century. *Journal of Micromechanics and Microengineering,* 2021, vol. 31 (8), 084002
- **S. DELLEA ; F. GIACCI ; A. F. LONGONI ; G. LANGFELDER.** In-plane and out-of-plane mems gyroscopes based on piezoresistive nems detection. *Journal of Microelectromechanical Systems,* 2015, vol. 24 (6), 1817-1826
- **M. GADOLA et al.** 1.3 mm2 nav-grade nems-based gyroscope. *Journal of Microelectromechanical Systems,* 2021, vol. 30 (4), 513-520
- **A. NIKAS et al.** A 83db sndr low power readout asic for piezoresistive nanogauge based gyroscopes. *IEEE International Symposium on Circuits and Systems,* 2016, 2238-2241
- **B. VAN DEN DOOL ; J. HUIJSING.** Indirect current feedback instrumentation amplifier with a common-mode input range that includes the negative roll. *IEEE Journal of Solid-State Circuits,* 1993, vol. 28 (7), 743-749